# EUROPÄISCHE PATENTANMELDUNG

(11) **EP 2 009 344 A1**
(43) Veröffentlichungstag der Anmeldung: **31.12.2008**
(21) Anmeldenummer: 07012415.1
(22) Anmeldetag: 25.06.2007
(51) Int. Cl.: F21K 7/00, H01L 27/15, H01L 25/075, G09F 13/22

(54) **Flächige Beleuchtungseinrichtung, Herstellungsverfahren für eine flächige Beleuchtungseinrichtung**

(71) Anmelder: Alcan Technology & Management AG, 8212 Neuhausen (CH)
(72) Erfinder: Werner, Martin, 78224 Singen (DE)
(74) Vertreter: Nüsse, Stephan

(57) **Zusammenfassung**

Die Erfindung geht aus von einer flächigen Beleuchtungseinrichtung (10, 20) mit auf einem Träger (1) angeordneten lichtemissionsfähigen Beleuchtungselementen (5) wobei ein Beleuchtungselement (5) einen Unterseitenkontakt (7) und einen Oberseitenkontakt (17) aufweist, wobei zur Stromversorgung der Unterseitenkontakt (7) mit einer ersten Stromzuleitung (3B) und der Oberseitenkontakt (17) mit einer zweiten Stromzuleitung (3A) kontaktiert ist. Erfindungsgemäß wird bei dem lichtemissionsfähigen Beleuchtungselement (5) der obere Kontakt (17) über einen Leitkleber (21) mit der zweiten Stromzuleitung (3A) kontaktiert.

## Beschreibung

Die Erfindung betrifft eine flächige Beleuchtungseinrichtung mit auf einem Träger angeordneten lichtemissionsfähigen Beleuchtungselementen, wobei ein Beleuchtungselement einen Unterseitenkontakt und einen Oberseitenkontakt aufweist, wobei zur Stromversorgung der Unterseitenkontakt mit einer ersten Stromzuleitung und der Oberseitenkontakt mit einer zweiten Stromzuleitung kontaktiert ist. Die Erfindung betrifft weiter ein Herstellungsverfahren für eine flächige Beleuchtungseinrichtung Herstellungsverfahren für eine flächige Beleuchtungseinrichtung, wobei auf einem Träger lichtemissionsfähige Beleuchtungselemente angeordnet werden, wobei ein Beleuchtungselement einen Unterseitenkontakt und einen Oberseitenkontakt aufweist, wobei zur Stromversorgung der Unterseitenkontakt mit einer ersten Stromzuleitung und der Oberseitenkontakt mit einer zweiten Stromzuleitung kontaktiert wird.

Eine Beleuchtungseinrichtung der eingangs genannten Art ist in bandförmiger Ausführung speziell mit einer Leiterbahnstruktur gemäß DE 103 19 525 A1 versehen.

Grundsätzlich sind flächige Beleuchtungseinrichtungen der eingangs genannten Art aus WO 2006/097225 bekannt. Darin sind, auf einer metallischen Folie als Träger angeordnet, Licht emittierende Beleuchtungselemente beschrieben. Der Träger ist mit einer isolierenden Schicht bedeckt. Auf der isolierenden Schicht sind Leiterbahnen als Stromzu- und Stromableitungen und dazwischen in Reihenschaltungen Beleuchtungselemente und Vorwiderstandsflächen angeordnet. Die Licht emittierenden Elemente sind in Form von Dioden gebildet, deren Anschlüsse an Anschlussflächen der Leiterbahnen befestigt werden. Zu diesem Zweck werden die Anschlüsse bei einem Bestückvorgang in die richtige Lage in Bezug auf die Anschlusskontaktflächen gebracht und mit Hilfe eines Leitklebers an diesem befestigt bzw. verklebt, wobei eine gute elektrische Verbindung sowie eine Verbindung einer guten Wärmeleitfähigkeit bewirkt werden soll. Alternativ können die Anschlüsse der Dioden auch an den Anschlusskontaktflächen verlötet werden. Die Dioden sind soweit in ein Material einer stabilisierenden Beschichtung eingebettet, dass ihre Licht abgebende Vorderseite frei liegt.

Diese Art des "Bondens" ist vergleichsweise aufwändig und fehleranfällig hinsichtlich einer guten elektrischen Verbindung sowie einer guten Wärmeleitfähigkeit.

Wünschenswert ist eine verbesserte Kontaktierung zwischen einem Beleuchtungselement und einer Leiterbahn.

Aufgabe vorliegender Erfindung ist es, eine flächige Beleuchtungseinrichtung zur Verfügung zu stellen, bei der die auf dem Träger angeordneten lichtemissionsfähigen Beleuchtungselemente zur Stromversorgung mit Stromzuleitungen in Form wenigstens einer Leiterbahn in verbesserter Weise elektrisch verbunden sind, d.h. kontaktiert, sind.

Die Aufgabe hinsichtlich der flächigen Beleuchtungseinrichtung wird mit einer Beleuchtungseinrichtung der eingangs genannten Art gelöst, bei der erfindungsgemäß bei dem lichtemissionsfähigen Beleuchtungselement der Oberseitenkontakt über einen Leitkleber mit der zweiten Stromzuleitung kontaktiert ist.

Die Aufgabe hinsichtlich des Herstellungsverfahrens wird mit einem Herstellungsverfahren der eingangs genannten Art gelöst, wobei erfindungsgemäß bei dem lichtemissionsfähigen Beleuchtungselement der Oberseitenkontakt über einen Leitkleber mit der zweiten Stromzuleitung kontaktiert wird.

Die Erfindung hat erkannt, dass der Oberseitenkontakt vergleichsweise leicht und dennoch sicher über einen Leitkleber mit der zweiten Stromzuleitung kontaktiert werden kann. Vorteilhaft entfallen die aus dem Stand der Technik bekannten Probleme hinsichtlich einer Kontaktierung eines oberen Kontakts mit der zweiten Stromzuleitung über Bonding-Drähte oder dgl. Vorliegend erweist sich der Bestückvorgang als erheblich vereinfacht, da die Anschlusskontaktierung mittels einem Leitkleber weniger strengen Anforderungen für eine Lagejustage unterliegt, was den Herstellungsaufwand für die flächige Beleuchtungseinrichtung erheblich verringert. Darüber hinaus ist bei der erfindungsgemäßen Verwendung eines Leitklebers zur Kontaktierung des Oberseitenkontakts mit der zweiten Stromzuleitung sowohl eine gute elektrische Verbindung als auch eine gute Wärmeleitfähigkeit gewährleistet - kalte Lötstellen, schlecht leitende Kontakte oder sich lösende Kontakte wie im Stand der Technik sind von vorneherein unterbunden.

Vorteilhafte Weiterbildungen der Erfindung sind den Unteransprüchen zu entnehmen und geben im Einzelnen vorteilhafte Möglichkeiten an, das oben erläuterte Konzept im Rahmen der Aufgabenstellung sowie hinsichtlich weiterer Vorteile zu realisieren.

Vorzugsweise bildet der Leitkleber zwischen dem Oberseitenkontakt und der zweiten Stromzuleitung einen elektrisch leitenden Pfad aus. Mit anderen Worten es wird der Leitkleber in Form einer linienförmigen - oder tropfenförmigen oder kuppelartigen Anordnung zwischen Oberseitenkontakt und zweiter Stromzuleitung angebracht. Vorzugsweise bildet der Leitkleber einen Brückenpfad. Letztere Ausbildung hat sich als bevorzugt erwiesen, um unterhalb des Leitklebers eine Isolierung anbringen zu können. Gemäß einer besonders bevorzugten Weiterbildung der Erfindung ist der Leitkleber und/oder das lichtemissionsfähige Beleuchtungselement und/oder die zweite Stromzuleitung über eine Isolation, vorzugsweise mittels einem Isolationskleber, isoliert. Insbesondere kann die Isolation, wie erläutert, unterhalb des elektrisch leitenden Pfads angeordnet sein. Im Rahmen einer besonders bevorzugten Weiterbildung grenzt der Isolationskleber direkt an einer Seitenfläche des lichtemmisionsfähigen Beleuchtungselements an.

Eine Beleuchtungseinrichtung gemäß dem Konzept der Erfindung lässt sich vergleichsweise einfach herstellen. Insbesondere kann im Rahmen des Herstellungsverfahrens zunächst das lichtemissionsfähige Beleuchtungselement mit seinem Unterseitenkontakt bevorzugt direkt auf einer ersten Stromzuleitung aufgeklebt werden. Die Stromzuleitung kann beispielsweise in Form wenigstens einer ersten Leiterbahn gebildet sein oder über eine elektrisch leitende Schicht des Trägers realisiert sein. Insbesondere kann die Klebung mittels eines Leitklebers zwischen dem Unterseitenkontakt und der ersten Stromzuleitung realisiert sein.

In einem darauf folgenden Verfahrensschritt kann das Beleuchtungselement über einen Isolationskleber zunächst seitlich isoliert werden. Dies hat den Vorteil, dass dadurch das Beleuchtungselement zusätzlich seitlich stabilisiert werden kann. Im Rahmen einer besonders bevorzugten Ausbildung kann der Isolationskleber als UV härtender Kleber ausgeführt sein.

In einem weiteren Herstellungsschritt kann über dem Isolationskleber eine Brücke aus Leitkleber zur zweiten Stromzuleitung gelegt werden. Die vorausgehende Isolierung und der z. Bsp. als Fluid aufgebrachte Leitkleber gewährleisten eine kurzschlusssichere und eine vergleichsweise gut elektrisch und wärmeleitende Verbindung zwischen dem Oberseitenkontakt des Beleuchungselements und der zweiten Stromzuleitung. Der Leitkleber kann ebenfalls als UV härtender Kleber ausgeführt sein.

Vorzugsweise handelt es sich beim Unterseitenkontakt um eine anodische Kontaktfläche und beim Oberseitenkontakt um eine kathodische Kontaktfläche. Möglich ist auch eine davon abweichende umgekehrte oder andersartige Anordnung der Kontaktflächen. Insbesondere kann je nach Zweckmäßigkeit ein Oberseitenkontakt auch als ein seitlich am Beleuchtungselement angebrachter Kontakt ausgeführt sein, soweit sich die Seite des Beleuchtungselements von der Unterseite unterscheidet.

Im Rahmen einer besonders bevorzugten Weiterbildung der Erfindung kann der Träger mit den darauf angeordneten lichtemissionsfähigen Beleuchtungselementen mit einer transparenten Siegelschicht, beispielsweise einer Folie und/oder einem Lack beschichtet sein. Im Rahmen einer Abwandlung ist es auch möglich, die auf dem Träger angeordneten lichtemissionsfähigen Beleuchtungselemente jeweils einzeln mit einem transparenten Siegel zu bedecken, vorzugsweise einzuschließen. Es eignet sich dazu insbesondere ein hochtransparentes Polymer, das beispielsweise in Tropfenform aufgebracht werden kann.

Als Licht emittierende Beleuchtungselemente sind beispielsweise Dioden, wie sog. LEDs (light emitting diodes) oder dergleichen geeignet.

Träger können beispielsweise Folien einschichtigen oder mehrschichtigen Aufbaues sein. Ein mehrschichtiger Folienaufbau kann, einander anliegend, eine elektrisch leitende Schicht, und auf einer Seite der elektrisch leitenden Schicht, eine elektrisch isolierende Schicht, enthalten.

Eine elektrisch leitende Schicht oder der Träger kann beispielsweise eine Metallschicht oder eine metallische Schicht sein. Die Metallschicht kann eine Metallfolie, wie beispielsweise eine Gold-. Silber-, Eisen-, Stahl-, Kupfer-, Zinn- oder Aluminiumfolie sein. Die Metallfolien können auch aus Legierungen enthaltend wenigstens eines der genannten Metalle sein. Bevorzugt sind Aluminiumfolien, resp. Folien aus Aluminiumlegierungen. Es ist ebenfalls möglich mehrschichtige Folien aus wenigstens zwei unterschiedlichen Metallen einzusetzen. Typische Dicken der genannten Metallfolien reichen von ca. 3 µm bis 300 µm, wobei für Aluminiumfolien Dicken von 7 µm bis 70 µm besonders geeignet sind. Statt der Metallfolien können auch dickere als die angegebenen 300 µm -Folien oder -Werkstoffe, wie beispielsweise Bänder, Bleche oder Profile eingesetzt werden. Beispielsweise kann dies erforderlich sein, wenn der elektrisch leitenden Schicht zugleich eine tragende Funktion zukommen soll oder Formstabilität erreicht werden soll. Zur Ableitung der durch die Licht emittierenden Beleuchtungselementen erzeugten Wärme kann die Oberfläche der Metallfolien oder -bleche durch Faltungen oder durch Anbringen von Kühlrippen an Profile vergrößert werden. Eine Metallschicht kann auch mittels eines elektrisch leitfähigen metallhaltigen Lackes, der auf ein Substrat, wie ein Kunststoffsubstrat oder Papier etc. aufgetragen ist, erzeugt werden.

Eine metallische Schicht kann eine -- insbesondere auf einem Kunststoff, beispielsweise in Folienform, abgeschiedene -- durch ein chemisches oder physikalisches Abscheideverfahren erzeugte metallische Schicht sein. Die Beschichtung kann durch ein chemisches Verfahren, wie Kunststoffgalvanisierung, oder durch Auftragen oder Aufsprühen von Lösungen, wie Kathodenzerstäubung, erfolgen. Beispiele für eine physikalische Abscheidung sind das Sputtern oder Aufdampfen im Vakuum. Ist die Metallschicht aufgesputtert oder in einem Vakuumdünnschichtverfahren abgeschiedene Metallschicht sein, so können die abgeschiedenen oder aufgedampften Metalle z.B. Gold, Silber, Kupfer, Eisen, Nickel, Zinn, Zink, Aluminium etc., Legierungen oder Mischungen davon sein oder die Schichten können diese Metalle enthalten. Aufgesputterte oder aufgedampfte Schichten können beispielsweise eine Dicke von 2 bis 200 nm (Nanometer) aufweisen.

Eine isolierende Schicht oder der Träger kann ein Papier, ein beschichtetes Papier, Halbkarton, Karton oder Pappe oder ein Kunststoff sein. Beschichtete Papiere können mit Wachsen, Hot Melt oder Kunststoffen beschichtete Papiere sein. Als Kunststoffe können beispielsweise Polyvinylchlorid, Polyolefine, wie Polyethylen oder Polypropylen, Polycarbonate, Polyamide, Polyester, Polyacrylnitrile, Polystyrole oder deren Co- oder Pfropfpolymere usw. eingesetzt werden. Als isolierende Schicht ist auch Gummi geeignet. Die isolierende Schicht aus Kunststoff liegt vorteilhaft als Folie vor. Die Folien können auch Laminate oder Schichtstoffe aus 2 oder mehreren Kunststoffschichten darstellen und beispielsweise durch Kaschieren oder Extrudieren hergestellt worden sein. Typische Dicken derartiger Folien liegen bei 12 µm bis 200 µm. Die isolierende Schicht kann auch in Dicken über die angegebenen 200 µm eingesetzt werden, beispielsweise als Platte oder Formteil, wenn der isolierenden Schicht zugleich eine tragende Funktion zukommen soll oder Formstabilität erreicht werden soll.

Eine elektrisch isolierende Schicht liegt bevorzugt als Kunststofffolie und die elektrisch leitende Schicht bevorzugt als Metallfolie vor. Die beiden Folien können mittels Primer, mittels Primer und Kleber oder mittels Kleber, durch Kaschieren, untereinander verbunden sein. In anderer Weise kann der Kunststoff als Schicht auf die Metallfolie extrusionskaschiert werden. Die Strom zuführenden Teile der Licht emittierenden Beleuchtungselemente werden in der Regel auf die elektrisch isolierende Schicht aufgedruckt, nass chemisch aufgetragen oder aufgedampft oder eine vollflächige Leiterschicht auf der isolierenden Schicht wird soweit entfernt, wie verdampft oder weggeätzt, dass die erforderlichen Leiterbahnen und Leiterbahnabschnitte mit der Wirkung eines Vorwiderstandes zurückbleiben.

Besonders vorteilhaft werden als Träger Folien wie hart gewalzte Aluminiumfolien eingesetzt. Eine Trägerfolie kann flächig mit einer isolierenden Schicht, beispielsweise mit einer Decklackschicht, als isolierende Schicht, versehen sein. Auf die Decklackschicht können beispielsweise im Tiefdruckverfahren, ein- oder mehrschichtig mit einer elektrisch leitenden Farbe, vorzugsweise einer Silberleitfarbe, die verschiedenen Leiterbahnen und Anschlusskontaktflächen aufgedruckt werden. Fallweise können mit einer weiteren Leitfarbe, wie einer silber- und/oder Grafit, vorzugsweise einer Grafitleitfärbe, die Vorwiderstände aufgedruckt werden. Dabei werden in einem Tiefdruckdurchgang die Stromzufuhr und der Stromverteilung in der Fläche der Beleuchtungseinrichtung dienenden Leiterbahnen als auch die Anschlussflächen für die Licht emittierenden Bauelemente in der Silberleitfarbe aufgedruckt. Vorteilhafter Weise werden die beispielsweise aus Grafitleitfarbe bestehenden Widerstandsflächen der Vorwiderstände, die durch vorzugsweise aus Silber bestehende Ein- und Ausleitungen gespeist werden, durch das Tiefdruckverfahren aufgedruckt. Die erforderliche Verlustleistung der Vorwiderstände wird durch die relativ großflächige Ausgestaltung der aufgedruckten Widerstandsflächen erreicht. Die Licht emittierenden Beleuchtungselemente werden beispielsweise mit einem silberhaltigen Leitkleber an den entsprechenden Anschlusskontaktflächen verklebt, oder an diesen verlötet. Silberhaltige Leitkleber besitzen einen sehr kleinen Wärmeleitkoeffizienten, so dass eine gute Wärmeableitung aus den Licht emittierenden Beleuchtungselementen bis hin zur metallischen Trägerfolie erfolgt.

Die einzelnen Beleuchtungselemente, bzw. Licht emittierenden Dioden können die während des Betriebes erzeugte Wärme in den Träger, z.B. die als Träger dienende metallische Trägerfolie, ableiten. Die einzelnen Beleuchtungselemente können eine Leistungsaufnahme von beispielsweise 0,1 Watt bis 5 Watt aufweisen. Nicht nur an schwache LEDs, mit z.B. 0,1 bis 0,5 Watt, sondern auch so genannte Power-LEDs mit z.B. 2 bis 5 Watt, bevorzugt 3 Watt, können eingesetzt werden. Je nach ihrer Anzahl können die LEDs mit einer Betriebsspannung von z. B. 20 V betrieben werden. Damit liegt die Betriebsspannung im Bereich von Kleinspannungen gemäß den VDE-Normen. Der Isolationsaufwand wird daher vorteilhafter Weise gering gehalten. Die LEDs können bevorzugt Halbleiterchips ohne Gehäuse sein, die direkt auf eine erste Stromzuführung aufgeklebt werden und dann gemäß dem Konzept der Erfindung mit einer zweiten Stromzuführung kontaktiert werden.

Die Licht emittierenden Beleuchtungselemente können als eine Abfolge von Einheiten, vorteilhaft eine Abfolge gleicher Einheiten, die sich in der Fläche in eine oder beide Richtungen erstrecken, angeordnet sein. Die Licht emittierenden Beleuchtungselemente lassen sich beispielsweise kontinuierlich in Form einer Trägerbahn herstellen, wobei die Breite und Länge der Trägerbahn an sich unkritisch ist und sich nach den Ausgangsmaterialien und den maschinellen Gegebenheiten richtet. Vorzugsweise sind Licht emittierenden Beleuchtungselemente, bahnförmig angeordnet, mit beispielsweise 1 bis 100 Einheiten über die Breite der Trägerbahn und 1 bis zu einer beliebigen Zahl an Einheiten, die sich über die Länge der Trägerbahn erstrecken. Zweckmäßig sind flächige Beleuchtungseinrichtungen deren fortlaufende Trägerbahn wenigstens eine Einheit breit und wenigstens zwei Einheiten lang ist. Bevorzugt sind 2 bis 50 Einheiten in Trägerbahnbreite. In Trägerbahnlänge sind 2 bis 200 Einheiten bevorzugt.

In einer besonders günstigen Ausführungsform liegen die Einheiten der flächigen Beleuchtungseinrichtung in Längsrichtung und/oder in Querrichtung jeweils in einer Flucht, resp. im Rapport. Die Einheiten können auch individuelle Außenbegrenzungen aufweisen. Eine spätere Aufteilung einer flächigen Beleuchtungseinheit in ausgewählt angeordnete Gruppierungen von Einheiten gestaltet sich entsprechend aufwendiger.

In der flächigen Beleuchtungseinrichtung ist vorteilhaft jede Einheit von einer endlosen Leiterbahn umringt. Die umringende Leiterbahn stellt Teil der Stromversorgung, resp. Stromzufuhr, innerhalb der flächigen Beleuchtungseinrichtung dar. Von der umringenden Leiterbahn führt eine Strom führende Bahn zur LED. Diese Strom führende Bahn weist in ihrer ganzen oder in einer teilweisen Länge ein Widerstand dar und formt damit den Vorwiderstand. Das Maß des Widerstandes der Strom führenden Bahn wird durch die Querschnittsfläche und/oder die Leitfähigkeit der Bahn oder eines Abschnittes der Bahn erreicht.

Jede Einheit kann mit der oder den benachbarten Einheiten über Leiterbahnen Strom führend miteinander verbunden sein.

An der flächigen Beleuchtungseinrichtung kann jede Einheit des Licht emittierenden Beleuchtungselementes, durch eine Ausnehmung in der isolierenden Schicht hindurch, elektrisch leitend mit dem Träger verbunden sein. Der Träger stellt dann die Stromableitung dar. Die Ausnehmung durch die isolierende Schicht hindurch, kann durch beispielsweise durch Durchstechen mittels eines nadelförmigen Instrumentes, durch mechanischen Abtrag, wie Ausstanzen oder Bohren, durch Ätzen oder Verdampfen mittels Elektronenstrahl oder Laserstrahl erfolgen. Der stromabführende Leiter vom Licht emittierenden Beleuchtungselement zur Trägerfolie kann ebenfalls eine Leiterbahn, wie vorbeschrieben, sein. Fallweise kann es sich als notwendig erweisen, den Kontakt zwischen der Leiterbahn und der Trägerfolie, durch die Ausnehmung in der isolierenden Schicht hindurch, zu verbessern oder überhaupt einzurichten. Dies kann durch Verbindung der Leiterbahn und der Trägerfolie mittels eines leitfähigen Lackes oder durch einen Lötpunkt, welche im Wesentlichen die Ausnehmung durchdringen, erfolgen.

Vorteilhaft liegen die Einheiten in Längsrichtung und/oder in Querrichtung jeweils in einer Flucht. Zwischen den Einheiten sind vorteilhaft Schneidezonen angeordnet. Die Schneidezonen sind zwischen den einzelnen Einheiten angeordnet und bilden somit Platz für die Schnittlinien zum späteren Vereinzeln von Einheiten oder Gruppen von Einheiten. Da vorteilhaft jede Einheit mit der oder den benachbarten Einheiten über Leiterbahnen Strom führend miteinander verbunden ist, können beliebige Einheiten abgeschnitten werden, die unabhängig voneinander funktionieren.

Zwischen jeder Einheit kann innerhalb der Schneidezone ein Trennschnitt angelegt werden und wenigstens eine Einheit aus der Beleuchtungseinrichtung ausgenommen oder von der Beleuchtungseinrichtung randständig abgetrennt werden. Das Abtrennen oder Ausnehmen von Einheiten oder Gruppen von Einheiten oder Gruppen von Einheiten in einer musterhaften Anordnung kann mechanisch durch Trennverfahren, wie Stanzen oder mittels Messer oder Schere erfolgen. Trennverfahren, wie Laserschneidverfahren, Trennen mittels Wasserstrahl und dergl. können ebenfalls angewendet werden. Die genannten Trennverfahren könne auch computerunterstützt gefahren werden. Dies ermöglicht, mit der Trennvorrichtung komplexe Muster von der flächigen Beleuchtungseinrichtung abzutrennen oder auszunehmen oder nicht linearen oder gekurvten Schnittlinien zu folgen.

Zum Betrieb der erfindungsgemäßen flächigen Beleuchtungseinrichtung kann wenigstens eine Leiterbahn, beispielsweise eine oder mehrere der endlosen Leiterbahnen, oder eine oder mehrere der die Einheiten verbindenden Leiterbahnen über eine Stromzuführung an den Strom angeschlossen werden. Ebenfalls wird über eine Stromabführung die elektrisch leitende Schicht an den Stromkreis angeschlossen. Jede Diode oder LED wird nun über die endlosen Leiterbahnen und die Strom führende Bahn, resp. Vorwiderstand, mit Strom versorgt und über die Stromabführung zur elektrisch leitenden Schicht wird der Stromkreis geschlossen.

Bei einer weiteren bevorzugten Ausgestaltung der Erfindung wird die flexible metallische Trägerfolie durch ein stabiles Verbundteil verstärkt, so dass selbsttragende Leuchtpaneele hergestellt werden können. Hierbei wird der Träger beispielsweise auf Platten aus einem kompakten, geschäumten oder wabenförmigen Material, wie eine Kunststoffpaneele, eine Holzpaneele, ein Kunststoffschaum oder eine Wabenplatte, durch Kleben, festgelegt, d.h. zu einem Verbundteil verarbeitet. Die Seite mit den Licht emittierenden Beleuchtungselementen, kann z.B. mit einem optisch transparenten, eine die Färbung des Lichtes verändernde oder einem eine diffuse Lichtverteilung bewirkenden opaken Kunststoffschutzschicht abgedeckt werden. Durch die Kunststoffschicht werden die Licht emittierenden Beleuchtungselemente, Leiterbahnen und Widerstände zudem in vorteilhafter Weise gegen mechanische und elektrische Einflüsse geschützt. Es können auch möglich, auf der einen Seite der flächigen Beleuchtungseinrichtung das stabile Verbundteil und auf der Seite der lichtemittierenden Beleuchtungselemente die Kunststoffschutzschicht anzuordnen. Es entsteht ein stabiles aufteilbares Sandwichelement mit Wärme ableitender und/oder formstabiler Rückseite und Licht abgebender Vorderseite. Zur Stromversorgung der LEDs kann beispielsweise eine Kontaktklammer zur Stromzuführung an wenigstens einer Stelle an eine der Leiterbahnen angeschlossen werden und anderseits kann die Stromabführung über eine Kontaktklammer, welche die elektrisch leitende Schicht berührt, erfolgen. Statt einer oder mehrerer Klammern können die Stromführungen auch an die Leiterbahnen oder elektrisch leitende Schicht angelötet oder anderweitig Strom führend, festgelegt werden.

Ausführungsbeispiele der Erfindung werden nun nachfolgend anhand der Zeichnung beschrieben. Diese soll die Ausführungsbeispiele nicht notwendigerweise maßstäblich darstellen, vielmehr ist die Zeichnung, wo zur Erläuterung dienlich, in schematisierter und/oder leicht verzerrter Form ausgeführt. Im Hinblick auf Ergänzungen der aus der Zeichnung unmittelbar erkennbaren Lehren wird auf den einschlägigen Stand der Technik verwiesen. Dabei ist zu berücksichtigen, dass vielfältige Modifikationen und Änderungen betreffend die Form und das Detail einer Ausführungsform vorgenommen werden können, ohne von der allgemeinen Idee der Erfindung abzuweichen. Die in der Beschreibung, in der Zeichnung sowie in den Ansprüchen offenbarten Merkmale der Erfindung können sowohl einzeln als auch in beliebiger Kombination für die Weiterbildung der Erfindung wesentlich sein. Zudem fallen in den Rahmen der Erfindung alle Kombinationen aus zumindest zwei der in der Beschreibung, der Zeichnung und/oder den Ansprüchen offenbarten Merkmale. Die allgemeine Idee der Erfindung ist nicht beschränkt auf die exakte Form oder das Detail der im folgenden gezeigten und beschriebenen bevorzugten Ausführungsform oder beschränkt auf einen Gegenstand, der eingeschränkt wäre im Vergleich zu dem in den Ansprüchen beanspruchten Gegenstand. Bei angegebenen Bemessungsbereichen sollen auch innerhalb der genannten Grenzen liegende Werte als Grenzwerte offenbart und beliebig einsetzbar und beanspruchbar sein.

Im einzelnen zeigt die Zeichnung in:

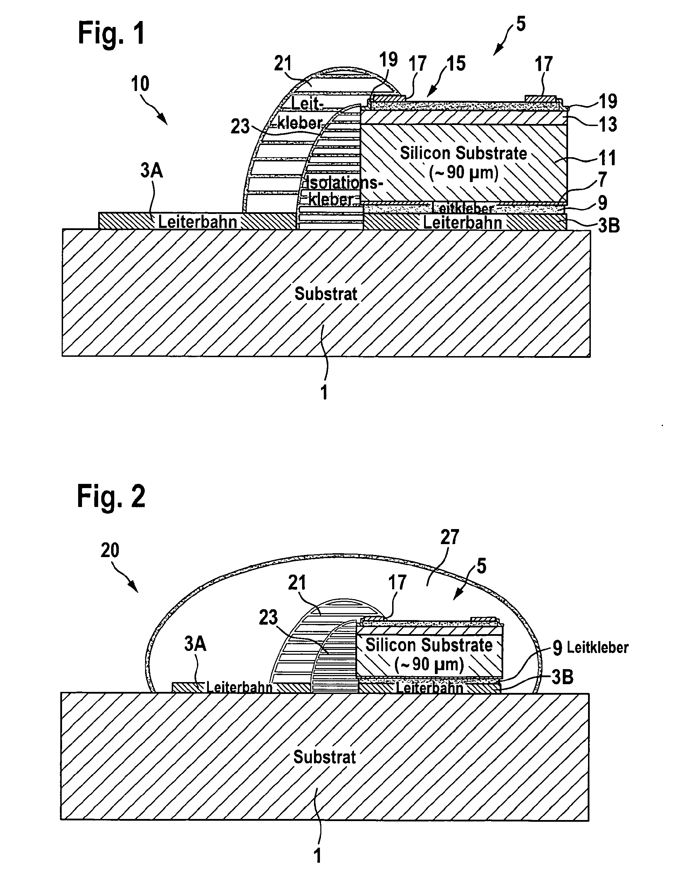

- Fig. 1: eine besonders bevorzugte Ausführungsform einer flächigen Beleuchtungseinrichtung im Querschnitt, bei der das lichtemissionsfähige Beleuchtungselement seitlich über einen Isolationskleber isoliert und stabilisiert ist und anschließend ein Oberseitenkontakt mittels einem durch einen Leitkleber ausgebildeten leitenden Brückenpfad mit einer zweiten Leiterbahn kontaktiert ist;
- Fig. 2: eine weitere Ausführungsform einer flächigen Beleuchtungseinrichtung im Querschnitt, bei der - anders als bei der Ausführungsform in Fig. 1 - jedes Beleuchtungselement einzeln durch ein hochtransparentes Polymer eingeschlossen und dadurch versiegelt ist.

Fig. 1 zeigt eine erste Ausführungsform einer flächigen Beleuchtungseinrichtung 10 in Form eines Lichtbandes, bei der auf einem aus Aluminiumfolie gebildeten flexiblen Trägersubstrat 1 eine erste Stromzuleitung 3A in Form einer ersten Leiterbahn und eine zweite Stromzuleitung 3B in Form einer zweiten Leiterbahn aufgedruckt ist und im weiteren die zweite Leiterbahn mit einem vertikal emittierenden Beleuchtungselement 5 in Form einer LED bestückt ist. Vorliegend ist das lichtemissionsfähige Beleuchtungselement 5 in Form der LED mit seinem Unterseitenkontakt 7 unter Verwendung eines Leitklebers 9 auf der zweiten Stromzuleitung 3B aufgeklebt. Das lichtemissionsfähige Beleuchtungselement 5, welches grundsätzlich auch ein geeignetes anderes Beleuchtungselement anstatt einer LED sein kann - beispielsweise eine Laserdiode oder eine sonstige elektrooptische lichtemittierende Struktur - ist vorliegend auf einem SiliziumSubstrat 11 aufgebaut, auf dessen Unterseite der Unterseitenkontakt 7 in Form eines aufgedampften Gold-Zinn-Kontaktes (AuSn) angebracht ist. Auf der Oberseite des Silizium-Substrats ist eine Metallschicht 13 aufgedampft oder epitaktisch oder in anderer geeigneter Weise aufgebracht, welche die emittierende Oberfläche 15 der LED trägt. Auf der emittierenden Oberfläche 15 sind vorliegend zwei seitlich angebrachte Kontaktflächen 17 - auch als Bonding-Flächen bezeichnet - angeordnet. Die Kontaktflächen 17 haben vorliegend eine Abmessung im Bereich von 130 µm x 130 µm. Die oberseitigen Randbereiche der Kontaktflächen 17 und der emittierenden Oberfläche 15 sind vorliegend durch eine Passivierungsschicht 19 jeweils isoliert. Vorliegend bildet der Oberseitenkontakt 17 einen Oberseitenkathodenkontakt und der Unterseitenkontakt 7 einen Unterseitenanodenkontakt.

Wie in Fig. 1 ersichtlich, lässt sich zur weiteren Fertigstellung der Beleuchtungseinrichtung 10 nach Aufbringen der LED der Oberseitenkontakt in Form einer Kontaktfläche 17 - anstatt üblicherweise mit vergleichsweise aufwendig anzubringenden und vergleichsweise unzuverlässigen Bondingdrähten - gemäß dem Konzept der Erfindung statt dessen über einen Leitkleber 21 mit der zweiten Stromzuleitung 3A kontaktieren.

Dazu wird im Rahmen des Herstellungsverfahrens zunächst das Beleuchtungselement 5 in Form der LED mit einem nicht leitenden und UV härtenden Isolationskleber 23 seitlich stabilisiert und dadurch an seiner Seitenfläche 25 isoliert. Anschließend wird die vorgenannte Brücke aus Leitkleber 21 von der katodischen Bond-Fläche in Form der Kontaktfläche 17 auf der Oberseite zur zweiten Leiterbahn gelegt. Der Leitkleber 21 wird anschließend ausgehärtet, gegebenenfalls UV gehärtet.

Dieses Verfahren hat sich als vergleichsweise einfach und sicher in der Kontaktierung erwiesen. Die Verwendung von Klebern anstatt aufwendigem Bond-Drähten, beispielsweise Au-Drähten, ist vergleichsweise günstig. Vorliegend lässt sich der Isolationskleber während der Herstellung in Tropfenform zwischen der zweiten Stromzuleitung 3A und dem Beleuchtungselement 5 anordnen und schmiegt sich durch Adhäsionskräfte getrieben selbsttätig an die Seitenfläche 25 des Beleuchtungselements 25 isolierend an. Gleichermaßen kann der räumlich gesehen kuppelförmig über den Isolationskleber liegende Leitkleber in Tropfenform auf den Bereich zwischen der Bond-Fläche und zweiter Stromzuleitung 3A aufgebracht und ausgehärtet werden. Die gesamte Anordnung erweist sich als besonders stabil und sicher hinsichtlich der elektrischen und Wärme-Leitfähigkeit. Das Konzept der Erfindung nutzt synergetisch die fixierenden und leitenden bzw. isolierenden Eigenschaften der Kleber.

In der in Fig. 1 gezeigten Ausführungsform ist die als bahnförmige mit einer Vielzahl von LEDs (Beleuchungselement 5) bestückten Substratbahn (Träger 1) und darauf aufgedruckten Leiterbahnen (Stromzuleitungen) 3A, 3B als eine Endlosstruktur mit einer nicht näher dargestellten weiteren transparenten Deckfolie bedeckt. Anschließend kann das so dargestellte Folienlaminat zusätzlich mit einem Siegellack versehen und versiegelt werden.

In einer zweiten besonders bevorzugten Ausführungsform kann alternativ die als Leiterbahn bezeichnete Struktur - aus Träger 1, Stromzuleitungen 3A, 3B und gebondeten Beleuchtungselementen 5 - auch versiegelt werden, indem jedes einzelne oder Gruppen von Beleuchtungselementen 5 jeweils mit einem hochtransparenten Polymer bedeckt wird. Vorliegend ist eine Einheit aus Stromzuleitungen 3A, 3B, des Beleuchtungselment 5 und die Kontaktierungsanordnung aus Leitkleber 21 und Isolationskleber 23 mit einem Tropfen 27 hochtransparenten Polymers bedeckt und eingeschlossen. Das Polymer kann wiederum leicht ausgehärtet werden und bietet somit zuverlässigen Schutz für jede einzelne Struktur aus Stromzuführung, Beleuchtungselement und Kontaktierungsanordnung.

Zusammenfassend geht die Erfindung aus von einer flächigen Beleuchtungseinrichtung 10, 20 mit auf einem Träger 1 angeordneten lichtemissionsfähigen Beleuchtungselementen 5 wobei ein Beleuchtungselement 5 einen Unterseitenkontakt 7 und einen Oberseitenkontakt 17 aufweist, wobei zur Stromversorgung der Unterseitenkontakt 7 mit einer ersten Stromzuleitung 3B und der Oberseitenkontakt 17 mit einer zweiten Stromzuleitung 3A kontaktiert ist. Erfindungsgemäß wird bei dem lichtemissionsfähigen Beleuchtungselement 5 der obere Kontakt 17 über einen Leitkleber 21 mit der zweiten Stromzuleitung 3A kontaktiert.

## Patentansprüche

1. Flächige Beleuchtungseinrichtung (10, 20) mit auf einem Träger (1) angeordneten lichtemissionsfähigen Beleuchtungselementen (5) wobei ein Beleuchtungselement (5) einen Unterseitenkontakt (7) und einen Oberseitenkontakt (17) aufweist, wobei zur Stromversorgung der Unterseitenkontakt (7) mit einer ersten Stromzuleitung (3B) und der Oberseitenkontakt (17) mit einer zweiten Stromzuleitung (3A) kontaktiert ist,
**dadurch gekennzeichnet, dass**
bei dem lichtemissionsfähigen Beleuchtungselement (5) der Oberseitenkontakt (17) über einen Leitkleber (21) mit der zweiten Stromzuleitung (3A) kontaktiert ist.

2. Beleuchtungseinrichtung (10, 20) nach Anspruch 1,
**dadurch gekennzeichnet, dass**
der Leitkleber (21) zwischen dem Oberseitenkontakt (17) und der zweiten Stromzuleitung (3A) einen elektrisch leitenden Pfad, vorzugsweise einen Brückenpfad, ausbildet.

3. Beleuchtungseinrichtung (10, 20) nach Anspruch 1 oder 2,
**dadurch gekennzeichnet, dass**
der Leitkleber (21) und/oder das lichtemissionsfähige Beleuchtungselement (5) und/oder die zweite Stromzuleitung (3A) über eine Isolation, vorzugsweise über einen Isolationskleber (23), isoliert ist.

4. Beleuchtungseinrichtung (10, 20) nach einem der Ansprüche 1 bis 3,
**dadurch gekennzeichnet, dass**
die Isolation, vorzugsweise der Isolationskleber (23), unterhalb des elektrisch leitenden Pfads angeordnet ist.

5. Beleuchtungseinrichtung (10, 20) nach einem der Ansprüche 1 bis 4,
**dadurch gekennzeichnet, dass**
der Isolationskleber (23) direkt an einer Seitenfläche (25) des lichtemissionsfähigen Beleuchtungselements (5) angrenzt.

6. Beleuchtungseinrichtung (10, 20) nach einem der Ansprüche 1 bis 5,
**dadurch gekennzeichnet, dass**
ein lichtemissionsfähiges Beleuchtungselement (5) als eine LED gebildet ist, vorzugsweise als eine vertikal emissionsfähige LED.

7. Beleuchtungseinrichtung (10, 20) nach einem der Ansprüche 1 bis 6,
**dadurch gekennzeichnet, dass**
der Unterseitenkontakt (7) mittels einem Leitkleber (9) mit der ersten Stromzuleitung (3B) kontaktiert ist.

8. Beleuchtungseinrichtung (10, 20) nach einem der Ansprüche 1 bis 7,
**dadurch gekennzeichnet, dass**
die erste Stromzuleitung (3B) in Form wenigstens einer ersten Leiterbahn gebildet ist, vorzugsweise das lichtemissionsfähige Beleuchtungselement (5) auf der Leiterbahn angeordnet ist.

9. Beleuchtungseinrichtung (10, 20) nach einem der Ansprüche 1 bis 8,
**dadurch gekennzeichnet, dass**
die zweite Stromzuleitung (3A) in Form wenigstens einer Leiterbahn gebildet ist, vorzugsweise das lichtemissionsfähige Beleuchtungselement (5) beabstandet von der Leiterbahn angeordnet ist.

10. Beleuchtungseinrichtung (10, 20) nach einem der Ansprüche 1 bis 9,
**dadurch gekennzeichnet, dass**
der Leitkleber (21) und/oder der Isolationskleber (23) ein UV-härtender Kleber ist.

11. Beleuchtungseinrichtung (10) nach einem der Ansprüche 1 bis 10,
**dadurch gekennzeichnet, dass**
der Träger (1) mit den darauf angeordneten lichtemissionsfähigen Beleuchtungselementen (5) mit einer transparenten Siegelschicht, insbesondere Folie und/oder Lack, beschichtet ist.

12. Beleuchtungseinrichtung (20) nach einem der Ansprüche 1 bis 11,
**dadurch gekennzeichnet, dass**
die auf dem Träger (1) angeordneten lichtemissionsfähigen Beleuchtungselemente (5) jeweils einzeln mit einem transparenten Siegel bedeckt sind, vorzugsweise eingeschlossen sind, vorzugsweise mit einem hochtransparenten Polymer.

13. Beleuchtungseinrichtung (10, 20) nach einem der Ansprüche 1 bis 12,
**dadurch gekennzeichnet, dass**
der Träger eine PET-Schicht, vorzugsweise Film, aufweist.

14. Beleuchtungseinrichtung (10, 20) nach einem der Ansprüche 1 bis 13,
**dadurch gekennzeichnet, dass**
der Träger (1) eine Aluminium-Schicht, vorzugsweise eine Folie, aufweist.

15. Beleuchtungseinrichtung nach einem der Ansprüche 1 bis 14,
**dadurch gekennzeichnet, dass**
der Träger mehrere Schichten aufweist, vorzugsweise der Träger eine elektrisch leitende und eine elektrisch isolierende Schicht aufweist.

16. Beleuchtungseinrichtung nach einem der Ansprüche 1 bis 15,
**dadurch gekennzeichnet, dass**
eine elektrisch leitende Schicht des Trägers die erste Stromzuführung darstellt, vorzugsweise das lichtemissionsfähige Beleuchtungselement auf der leitenden Schicht des Trägers angeordnet ist.

17. Beleuchtungseinrichtung nach einem der Ansprüche 1 bis 16,
**dadurch gekennzeichnet, dass**
eine elektrisch leitende Schicht des Trägers die zweite Stromzuführung darstellt, vorzugsweise das lichtemissionsfähige Beleuchtungselemente auf der leitenden Schicht des Trägers angeordnet ist.

18. Beleuchtungseinrichtung (10, 20) nach einem der Ansprüche 1 bis 17,
**dadurch gekennzeichnet, dass**
die Licht emittierenden Beleuchtungselemente eine Abfolge gleicher Einheiten auf einer fortlaufenden Trägerbahn, vorzugsweise auf einer elektrisch isolierenden Schicht des Trägers angeordnet, sind.

19. Beleuchtungseinrichtung (10, 20) nach einem der Ansprüche 1 bis 18,
**dadurch gekennzeichnet, dass**
die fortlaufende Trägerbahn wenigstens eine Einheit breit und wenigstens zwei Einheiten lang ist.

20. Beleuchtungseinrichtung (10, 20) nach einem der Ansprüche 1 und 19,
**dadurch gekennzeichnet, dass**
die Einheiten in Längsrichtung und/oder in Querrichtung jeweils in einer Flucht liegen.

21. Beleuchtungseinrichtung (10, 20) nach einem der Ansprüche 1 bis 20, **dadurch gekennzeichnet, dass**
jede Einheit von einer endlosen Leiterbahn umringt ist.

22. Beleuchtungseinrichtung (10, 20) nach einem der Ansprüche 1 bis 21, **dadurch gekennzeichnet, dass**
jede Einheit mit der oder den benachbarten Einheiten über Leiterbahnen Strom führend verbunden ist.

23. Beleuchtungseinrichtung nach einem der Ansprüche 1 bis 22, **dadurch gekennzeichnet, dass**
in jeder Einheit das Licht emittierende Beleuchtungselement durch eine Ausnehmung in der elektrisch isolierenden Schicht hindurch elektrisch leitend mit der elektrisch leitenden Schicht des Trägers verbunden ist.

24. Beleuchtungseinrichtung (10, 20) nach einem der Ansprüche 1 bis 23, **dadurch gekennzeichnet, dass**
die Einheiten in Längsrichtung und/oder in Querrichtung jeweils in einer Flucht liegen und zwischen den Einheiten Schneidezonen angeordnet sind.

25. Beleuchtungseinrichtung (10, 20) nach einem der Ansprüche 1 bis 24 in Form eines Lichtbandes.

26. Herstellungsverfahren für eine flächige Beleuchtungseinrichtung, vorzugsweise für eine flächige Beleuchtungseinrichtung (10, 20) nach einem der Ansprüche 1 bis 25, wobei
auf einem Träger (1) lichtemissionsfähigen Beleuchtungselemente (5) angeordnet werden, wobei ein Beleuchtungselement (5) einen Unterseitenkontakt (7) und einen Oberseitenkontakt (17) aufweist, wobei zur Stromversorgung der Unterseitenkontakt (7) mit einer ersten Stromzuleitung (3B) und der Oberseitenkontakt (17) mit einer zweiten Stromzuleitung (3A) kontaktiert wird,
**dadurch gekennzeichnet, dass**
bei dem lichtemissionsfähigen Beleuchtungselement (5) der Oberseitenkontakt (17) über einen Leitkleber (21)mit der zweiten Stromzuleitung (3A) kontaktiert wird.

27. Herstellungsverfahren nach Anspruch 26,
**dadurch gekennzeichnet, dass**
das Beleuchtungselement (5) mit seinem Unterseitenkontakt (7) auf eine ersten Stromzuleitung (3B) geklebt wird.

28. Herstellungsverfahren nach Anspruch 26 oder 27,
**dadurch gekennzeichnet, dass** das Beleuchtungselement (5) über einen Isolationskleber (23) seitlich isoliert wird.

29. Herstellungsverfahren nach einem der Ansprüche 26 bis 28,
**dadurch gekennzeichnet, dass** über dem Isolationskleber (23) eine Brücke aus Leitkleber (21) zur zweiten Stromzuleitung (3A) gelegt wird.

30. Herstellungsverfahren nach einem der Ansprüche 26 bis 29,
**dadurch gekennzeichnet, dass**
das Beleuchtungselement (5) versiegelt wird.
